# EUROPEAN PATENT APPLICATION

(11) **EP 1 788 640 A1**
(43) Date of publication of application: **23.05.2007**
(21) Application number: 05767394.9
(22) Date of filing: 27.07.2005
(51) Int. Cl.: H01L 33/00, F21S 2/00

(54) **LIGHT EMITTING MODULE AND PRODUCTION METHOD THEREFOR**

(30) Priority: 28.07.2004 JP 2004220850
(71) Applicant: SHARP KABUSHIKI KAISHA, Osaka-shi, Osaka 545-8522 (JP)
(72) Inventor: TACHIBANA, Shinsuke, Nara 639-0266 (JP); TANAMURA, Hiromasa, Nara 633-0004 (JP); SANNOMIYA, Hitoshi, Osaka-shi, Osaka 546-0033 (JP)
(74) Representative: Müller, Frithjof E.
(86) International application number: PCT/JP2005/013752
(87) International publication number: WO 2006/011522

(57) **Abstract**

A light emitting module capable of flexibly accommodating a wide range of applications, and a production method capable of easily producing such a light emitting module. A 1.8mm-thick glass substrate is used as a first substrate (1). A circuit pattern (10) as shown in Fig. 1 is formed. Circuit forming silver paste is used as a conduction layer (2). Silver paste is printed on the surface of the first substrate (1) by a screen printing method, and then it is heat-cured for 40 min at 150°C. Conductive bonding silver paste as a conductive bonding layer (3) is printed on land patterns (22, 22) at the opposite ends of a gap (23) by a screen printing method. Then, a chip LED (4) as a light emitting element is used to mount the opposite poles of each chip LED by using a mounter so as to allow them conduct with each other by means of conductive bonding silver paste printed on the land patterns (22, 22). Then, the silver paste is heat-cured for 10 min at 150°C to bond the chip LED (4).

## Description

### FIELD OF THE INVENTION

The present invention relates to a light emitting module and a method for producing the same, more specifically, a light emitting module which can be used in a light emitting device, for example, a small-sized illumination wherein it is combined with a solar battery or some other cell, a large-sized illumination such as a wall surface illumination, a guide sign, or a warning light, and a method for producing the same.

### BACKGROUND ART

Hitherto, the main current of such a light emitting module has been of a type wherein a metallic substrate as a base plate is electrically insulated with an insulating layer and a circuit pattern is formed thereon, thereby mounting a light emitting diode (LED), as described in Patent Document 1, or of a type wherein a glass epoxy substrate which does not transmit any visible ray is used as a base to form a circuit pattern, thereby mounting an LED, as described in Patent Document 2.

Patent Document 1: Japanese Unexamined Patent Publication No. 2000-31546
Patent Document 2: Japanese Unexamined Patent Publication No. 2001-351418

### DISCLOSURE OF THE INVENTION

### Problems to be solved by the invention

However, the light emitting modules described in Patent Documents 1 and 2 are each formed only by a fixed method using the specified substrate. The modules each have a drawback that the use purpose thereof is limited since the module does not transmit any visible ray, the module has a low transmittance and neither has flexibility nor endurance out of doors. When a chip LED is mounted, creamy solder is generally used to mount the chip. Thus, heat resistance is required; therefore, the kind of the substrate on which the chip is mounted is limited. Furthermore, it is necessary to use a reinforcing member or the like in order to reinforce the chip LED.

An object of the invention is to solve such problems in the prior art and provide a light emitting module which can be applied to a wide use scope with flexibility, for example, which can have visible-ray-transmissibility, have a high reliability, have an excellent endurance, or have reflecting performance in accordance with the use purpose of the module; and a production method making it possible to produce such a light emitting module easily.

### Means for solving the problems

According to a first aspect of the invention, provided is a light emitting module, comprising a structure wherein over a first substrate having at least electric non-conductance, an electroconductive layer, an electroconductive adhesive layer, light emitting elements the number of which is predetermined, a transparent adhesive layer, and a second substrate having translucency are successively laminated in this order, wherein the electroconductive layer has a circuit pattern for causing the light emitting elements to emit light. The electroconductive adhesive layer attains electrical connection between the circuit pattern and the light emitting elements.

According to a second aspect of the invention, provided is a light emitting module, comprising a first substrate having electric non-conductance, and one structure wherein at least an electroconductive layer, an electroconductive adhesive layer and light emitting elements the number of which is predetermined are successively laminated in this order, the structure being over the first substrate and being sandwiched between second substrate having translucency and third substrate, and an adhesive layer being interposed between each of the second and third substrates and the structure.

According to a third aspect of the invention, provided is a light emitting module, comprising a first substrate having electric non-conductance, and a plurality of structures in each of which at least an electroconductive layer, an electroconductive adhesive layer and light emitting elements the number of which is predetermined are successively laminated in this order, the structures being over the first substrate, being connected to each other in a planar form, and being sandwiched between second substrate having translucency and third substrate, and an adhesive layer being interposed between each of the second and third substrates and the structures.

According to a fourth aspect of the invention, provided is a method for producing a light emitting module, comprising the steps of printing or painting an electroconductive paste on a first substrate into a predetermined pattern, and then setting the paste thermally, thereby yielding a circuit pattern of an electroconductive layer.

According to a fifth aspect of the invention, provided is a method for producing a light emitting module according to the first, second or third aspect, comprising the steps of laminating a metal foil on a first substrate through an adhesive, painting a resist material on this metal foil, radiating light thereon into a predetermined pattern, developing the resist material, etching unnecessary portions to remove the portions, and then removing the resist material, thereby yielding a circuit pattern of an electroconductive layer.

According to a sixth aspect of the invention, provided is a method for producing a light emitting module according to the first, second or third aspect, comprising the steps of forming a metallic film on a first substrate by vapor deposition or sputtering, painting a resist material on this metal film, radiating light thereon into a predetermined pattern, developing the resist material, etching unnecessary portions to remove the portions, and then removing the resist material, thereby yielding a circuit pattern of an electroconductive layer.

According to a seventh aspect of the invention, provided is a method for producing a light emitting module according to the first, second or third aspect, comprising the steps of: using an electroconductive paste for adhesion to form a predetermined pattern of an electroconductive adhesive layer on a first substrate when light emitting elements are caused to adhere to an electroconductive layer through the electroconductive adhesive layer; mounting the light emitting elements on the pattern; and subsequently setting the paste thermally.

According to an eighth aspect of the invention, provided is a method for producing a light emitting module according to the first, second or third aspect, comprising the steps of: using creamy solder to form a predetermined pattern of an electroconductive adhesive layer on a first substrate when light emitting elements are caused to adhere to an electroconductive layer through the electroconductive adhesive layer; mounting the light emitting elements on the pattern; and subsequently subjecting the resultant to heating treatment by means of a reflow furnace.
According to a ninth aspect of the invention, provided is a light emitting device comprising a light emitting module according to the first, second or third aspect, and a solar battery.

### Advantageous effects of the invention

The light emitting module according to the first aspect of the invention can be applied to a wide use scope with flexibility, for example, the module is capable of transmitting visible rays or has a high reliability, excellent endurance or reflecting performance in accordance with the use purpose thereof.

The light emitting module according to the second aspect of the invention can be a light-transmissible light emitting module having a high reliability when, for example, a glass substrate is used as the second and third substrates.

The light emitting module according to the third aspect of the invention can be a light emitting module having a large area.

The light emitting module producing method according to the fourth aspect of the invention makes it possible to use a PET (polyethylene terephthalate) film, which is advantageous in costs, as the first substrate by use of an electroconductive paste which can be cured at a temperature of 150 °C or lower, such as silver paste, and form a circuit pattern on the first substrate. Furthermore, even if a glass substrate or the like is used as the first substrate, the adhesiveness between the first substrate and the electroconductive layer can be made good by changing the kind of the electroconductive paste.

The light emitting module producing method according to the fifth aspect of the invention makes it possible to form a circuit pattern easily on a substrate which can resist a used etching solution.

The light emitting module producing method according to the sixth aspect of the invention makes it possible to form a circuit pattern easily on a substrate which can resist a used etching solution.

The light emitting module producing method according to the seventh aspect of the invention makes it possible to use a PET film, which is advantageous in costs, as the first substrate by use of an electroconductive paste which can be cured at a temperature of 150 °C or lower, such as silver paste, and mount light emitting elements on the circuit pattern formed on the first substrate. Furthermore, a paste having a good adhesiveness can be used as the electroconductive adhesive paste for the electroconductive adhesive layer in accordance with the kind of the electroconductive layer, which constitutes the circuit pattern.

The light emitting module producing method according to the eighth aspect of the invention makes it possible to provide a light emitting module wherein the adhesiveness between the light emitting elements and the electroconductive film, which constitutes a circuit pattern, becomes higher so as to exhibit a higher reliability in the case of using the first substrate that can resist a reflow step and is made of a glass substrate or a polyimide film, for example.
The light emitting module according to the ninth aspect of the invention makes it possible to realize a light emitting device giving the above-mentioned distinctive effects which the light emitting module produces.

### BRIEF DESCRIPTION OF THE DRAWINGS

Fig. 1 is a schematic plan view which schematically illustrates a light emitting module according to the invention.
Figs. 2 shows a sectional view taken along line A-A' in Fig. 1, and a sectional view taken along line B-B' in Fig. 1.
Fig. 3 is a plan view which illustrates a circuit pattern necessary for connecting light emitting elements.
Fig. 4 is a schematic sectional view which schematically illustrates another light emitting module according to the invention.
Fig. 5 is a schematic plan view which schematically illustrates still another light emitting module according to the invention.
Figs. 6 shows a sectional view taken along line C-C' in Fig. 5 and a sectional view taken along line D-D' in Fig. 5.

### Explanation of reference numbers

1: first substrate
2: electroconductive layer
3: electroconductive adhesive layer
4: chip LED (light emitting element)
5: transparent adhesive layer
6: second substrate
7: wiring
8: adhesive layer
9: third substrate
10: circuit pattern
22: land pattern
23: gap
31: structure
111: structure

### BEST MODE FOR CARRYING OUT OF THE INVENTION

In the light emitting module according to the first aspect of the invention, its first and second substrate are each preferably a film, a glass substrate, or a plastic substrate. In this case, a light emitting module having a wide use purpose can be provided. At this time, the first and second substrates are each more preferably a glass plate or plastic plate having a thickness of, for example, about 0.1 to 10 mm. In this case, it is preferred to decide a combination of raw materials, considering matters that they are easily available to give an advantage in costs and the combination is excellent in reliability and suitable for the use purpose, and some other matter.

In the light emitting module according to the first aspect of the invention, its electroconductive layer may be made of an electroconductive paste, a metal foil, or a metal film. In this case, a light emitting module having a wide use purpose can easily be provided. The metal foil or metal film is preferably a foil or film having a thickness of, for example, about 0.01 to 0.1 mm and made of silver, aluminum, gold, copper or the like. It is necessary to select the foil or film to be used, considering the usage of each thereof, the size of the light emitting module, costs, the kind of the first substrate, or the like.

In the light emitting module according to the first aspect of the invention, it is allowable that its first substrate is a film and the film has therein a metal foil layer or a metal film layer. In this case, the module can have a laminate structure wherein light obtained by leakage of light which the light emitting elements emit toward the first substrate side can be reflected on the metal foil layer or the metal film layer.
In this case, about the film having the laminate structure, the light emitting element side thereof needs to be transparent. Examples of such a film include a PET film or PEN (polyethylene naphthalate) film. The metal foil layer or metal film layer referred to herein is, for example, a foil layer or film layer having a thickness of about 7 to 20 µm and made of aluminum, silver or the like.

The circuit pattern in the light emitting module according to the first aspect of the invention is preferably a pattern wherein a plurality of lines in each of which light emitting elements are connected in series are further connected in parallel to each other. In this case, the light emitting elements can be caused to emit light into a scattered dot pattern with more ease and more certainty.

In the light emitting module according to the first aspect of the invention, its transparent adhesive layer is preferably made of low-temperature crosslinking type EVA (ethylene vinyl acetate) which can be crosslinked, for example, at about 100 °C to about 130 °C. In this case, a plastic substrate having a low heat-resistance temperature, such as polycarbonate, can be used as the first and second substrates.

In the light emitting module according to the second or third aspect of the invention, its third substrate is preferably a film, a glass substrate, or a plastic substrate. In this case, a light emitting module having a wide use purpose can be provided. At this time, its first and second substrates are each more preferably a glass plate or plastic plate having a thickness of, for example, about 0.1 to 10 mm. In this case, it is preferred to decide a combination of raw materials thereof, considering matters that they are easily available to give an advantage in costs and the combination is excellent in reliability and suitable for the use purpose, and some other matter.

In the light emitting module according to the second or third aspect of the invention, between its third substrate and its adhesive layer, a reflecting layer covering the whole or a part of the surface of the third substrate may be formed. In this case, the module can have a structure wherein light obtained by leakage of light which the light emitting elements emit toward the first substrate side can be reflected on the reflecting layer.

With reference to the attached drawings, three embodiments of the invention will be described hereinafter only in order to shown examples thereof.

### Embodiment 1

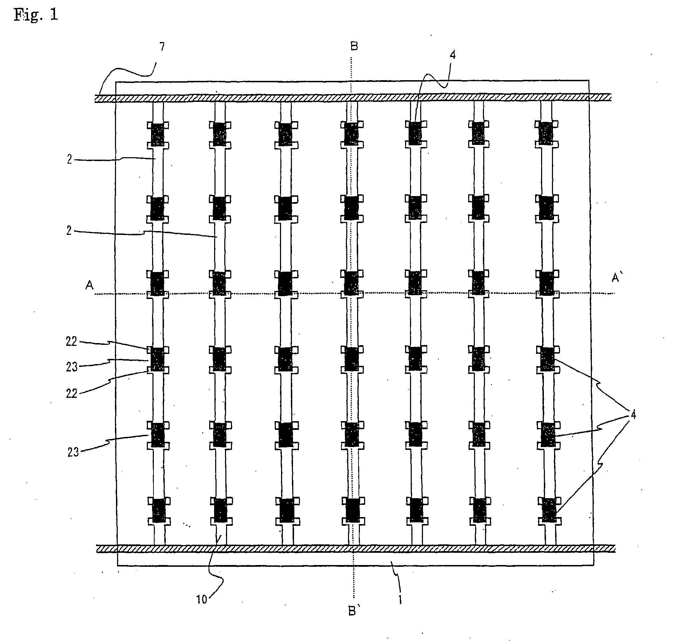

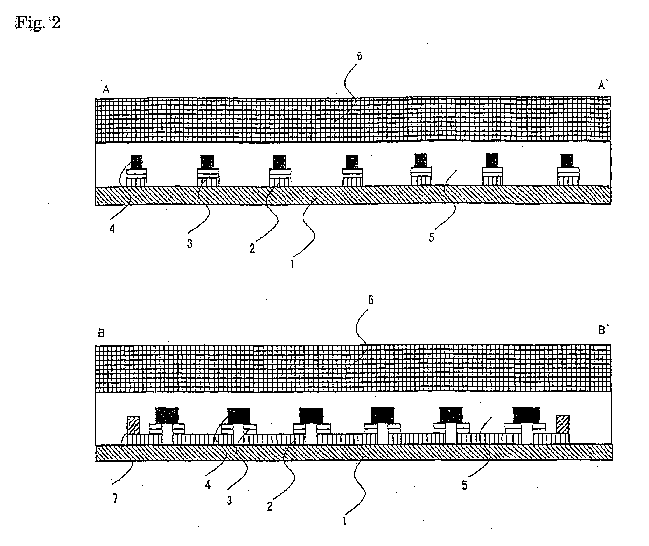

With reference to Figs. 1 to 3, an embodiment 1 is described. As a first substrate 1 having electric non-conductance, a glass substrate 1.8 mm in thickness was used. The first substrate 1 may be a plastic substrate or a film, and can be selected considering the use purpose or use form.

When the module is used in combination of a natural lighting type module or a solar battery such as a thin film see-through type solar battery or is used in a curtain wall on a side face of a building, a light-transmissible insulating substrate is used as the first substrate if the substrate needs to transmit light. At this time, as the first substrate, there is used a substrate in a light-transmissible grade, such as a glass substrate, a PET substrate, or a polycarbonate (PC) substrate. For outdoor illuminations, which are desired to have damp proofing property, such as a street light, the damp proofing property can be certainly kept by using a glass substrate.

As the first substrate 1, a three-layer film formed by sandwiching aluminum foil, such as PET/Al/PET, can be used. When light-transmissibility is desired, it is advisable to use a glass substrate, a fluorine type film, or a film on which glass fiber or the like is laminated.

A circuit pattern 10 as shown in Fig. 1 was formed. As an electroconductive layer 2, silver paste, which is an electroconductive paste for forming circuits, was used. The silver paste was printed by screen printing, so as to give a print thickness of 50 µm. Thereafter, the silver paste was thermally cured at a temperature of 150 °C for 30 minutes.

The silver paste includes at least silver powder as a filler, resin such as a binder, and a solvent. The binder is appropriately selected from polyester, phenolic and epoxy binders, or a mixture thereof in accordance with the kind of the first substrate 1, considering the adhesiveness to the first substrate 1, the shrinkability, and others.

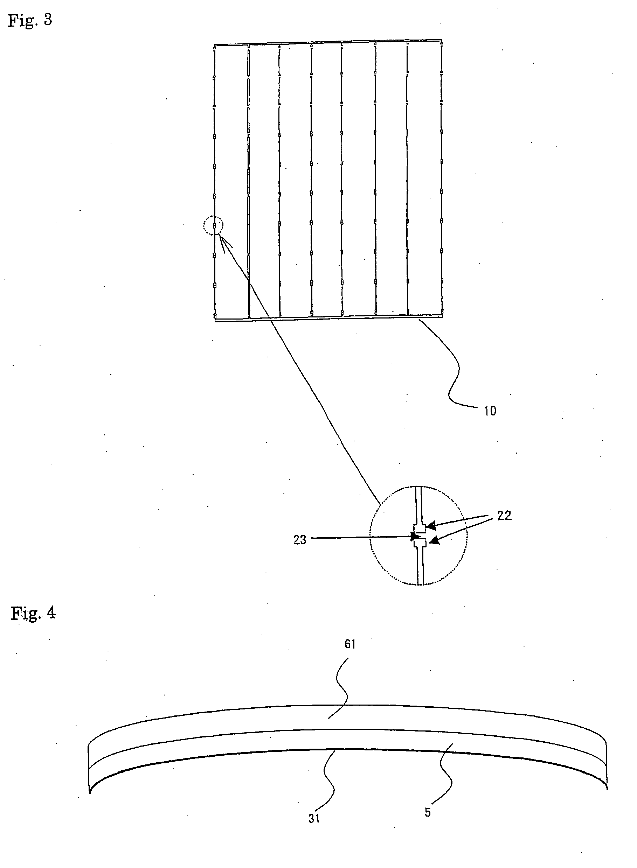

Next, screen printing was used to print an electroconductive silver paste for adhesion as an electroconductive adhesive layer 3 onto land patterns 22/22 at both ends of each gap 23 in the circuit pattern 10 as illustrated in Fig. 3. The printing method was use in this case; however, the silver paste may be painted by use of a dispenser or the like. In accordance with the physical property of the used electroconductive silver paste for adhesion, either of the methods can be selected considering the stability of the adhesion.

Next, each chip LED 4 as a light emitting element was used, and the chip LED 4 was mounted with a mounter in such a manner that both polarities of the chip LED 4 were made electrically conductive through the electroconductive silver paste for adhesion printed on the land patterns 22/22 at both the ends of each of the gaps 23 for the gap 23 not to cause electric non-conductance of the circuit pattern 10. Thereafter, the silver paste was thermally cured at a temperature of 150 °C for 10 minutes to attain the adhesion of the chip LED 4.

Since the glass substrate, which has heat resistance, is used as the first substrate 1, creamy solder may be used as the electroconductive layer 2 in order to improve the adhesiveness to the chip LED 4. It is allowable to print the cream solder onto the land patterns 22/22 by screen printing, mount the chip LED 4, and cause the resultant to pass through a reflow furnace so as to bond the chip LED.

An EVA layer was used as a transparent adhesive layer 5. As a second substrate 6 having translucency, a glass substrate 4.0 mm in thickness was used. The EVA layer 5 for bonding the first substrate 1 and the second substrate 6 to each other is formed by sandwiching EVA bodies having a larger thickness than the height of the chip LEDs 4 to protect the chip LEDs 4, keeping the resultant at a temperature of 130 °C for 20 minutes to melt the EVA bodies, and then keeping the resultant at a temperature of 150 °C for 45 minutes to crosslink the EVA.

The light emitting module produced in this way has an excellent reliability. Since the module transmits light, the light emitting module does not hinder natural light in the daytime from being gathered even if the light emitting module is set onto a face of a natural lighting type solar battery or a see-through type solar battery which is opposite to the light-receiving face of the solar battery. The light emitting module does not hinder natural light in the daytime from being gathered even if the module is set onto the rear side face of a glass plate or polycarbonate plate for gathering natural light in the daytime in an arcade, a street or the like. Accordingly, a light-transmissible light emitting module which can endure outdoor use sufficiently to exhibit a high reliability can be provided by a simple production method.
In the light emitting module of the invention, the use of the chip LEDs 4 makes it possible to watch or perceive the light emitting body from both faces thereof through light emitted from the gaps 23 of the circuit pattern 10 made from the electroconductive paste or the like toward the side of the second substrate 6 having translucency, or through light reflected on the first substrate 1. Accordingly, the module can be used in a warning light at a median strip in a road, a warning light in a road side strip, a side strip illumination at a road corner, or the like.

### Embodiment 2

With reference to Figs. 1 to 4, an embodiment 2 is described. As a first substrate 1, there was used a three-layer film wherein a black PET layer (thickness: 50 µm), an Al layer (thickness: 7 µm) and a white PET layer (thickness: 50 µm) were laminated inwards from the outside. A circuit pattern 10 as illustrated in Fig. 3 was formed.

As an electroconductive layer 2, an aluminum foil was used. Specifically, aluminum foils each having a thickness of about 10 µm were bonded onto both surfaces of PET, a resist material (photosensitive film) was bonded thereto, light was radiated to the film into a predetermined pattern, the film was developed, the resultant was subjected to etching, and resist material was removed to yield a desired circuit pattern 10.

As the electroconductive layer 2, aluminum foil was used in this case. However, foil of a different metal, such as copper foil or silver foil, may be used. It is necessary to select appropriate foil in accordance with the use purpose, considering the external appearance. At this time, as an etching solution, a solution of ferric chloride or the like can be used in the case of aluminum foil. In the case of copper foil, a phosphoric acid based etching solution or the like can be used. In this case, the metal foil was caused to adhere with an adhesive; however, the electroconductive layer 2 which is a metal film may be formed by sputtering or vapor deposition.

Next, screen printing was used to print an electroconductive silver paste for adhesion as an electroconductive adhesive layer 3 onto land patterns 22/22 at both ends of each gap 23. The printing method was use in this case; however, the silver paste may be painted by use of a dispenser or the like. In accordance with the physical property of the used electroconductive silver paste for adhesion, either of the methods can be selected considering the stability of the adhesion.

Thereafter, each chip LED 4 as a light emitting element was used, and the chip LED 4 was mounted with a mounter in such a manner that both polarities of the chip LED 4 were made electrically conductive through the electroconductive silver paste for adhesion printed on the land patterns 22/22 at both the ends of each of the gaps 23 for the gap 23 not to cause electric non-conductance of the circuit pattern 10. Thereafter, the silver paste was thermally cured at a temperature of 150 °C for 10 minutes to attain the adhesion of the chip LED 4. In this way, a structure 31 was formed.

An EVA layer was used as a transparent adhesive layer 5. As a second substrate 6 having translucency, a glass plate, 4.2 mm in thickness, which was a curved substrate 61 was used, as illustrated in Fig. 4. The EVA layer 5 for bonding the three-layer film as the first substrate 1 and the curved substrate 61 as the second substrate 6 to each other is formed by sandwiching EVA bodies having a larger thickness than the height of the chip LEDs 4 to protect the chip LEDs 4, keeping the resultant at a temperature of 140 °C for 20 minutes to melt the EVA bodies, and then keeping the resultant at a temperature of 150 °C for 45 minutes to crosslink the EVA. This way makes it possible to provide a high-reliability curved light emitting module excellent in damp proofing property.

In the case of using a polycarbonate substrate as the curved substrate 61 of the second substrate 6, it is advisable to use, as the EVA, EVA which can be crosslinked at a low temperature of about 100 to 130 °C. In the case of using a fluorine type film or some other film as the second substrate 6, it is necessary to paint a damp proofing coating material for protecting the electroconductive layer 2 and the electroconductive adhesive layer 4 since damp penetrates into the layers. Depending on a place where the module is used, it is necessary to add an ultraviolet absorbent or the like. According to the curved plate 61, it is possible to provide a flexible light emitting module which can be wounded onto a columnar object.

### Embodiment 3

With reference to Figs. 1 to 3 and Figs. 5 and 6, an embodiment 3 is described. As first substrates 1, there were used 4 rectangular PET sheets (each sheet size: 268 mm x 300 mm) having a thickness of 188 µm. A circuit pattern 10 as illustrated in Fig. 3 was formed onto each of the first substrates 1. As an electroconductive layer 2, silver paste for forming circuits was used. Silver paste was printed thereon by screen printing, so as to give a print thickness of 50 µm. Thereafter, the paste was thermally cured at a temperature of 150 °C for 30 minutes.

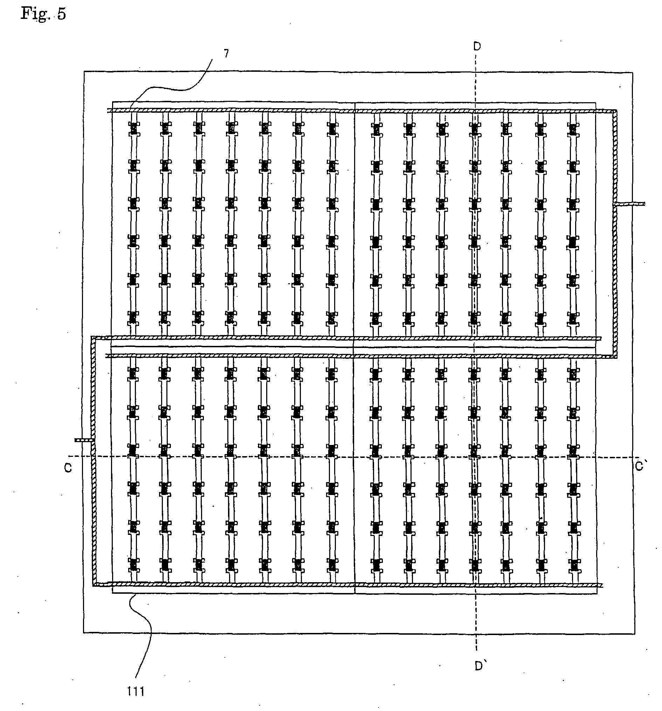

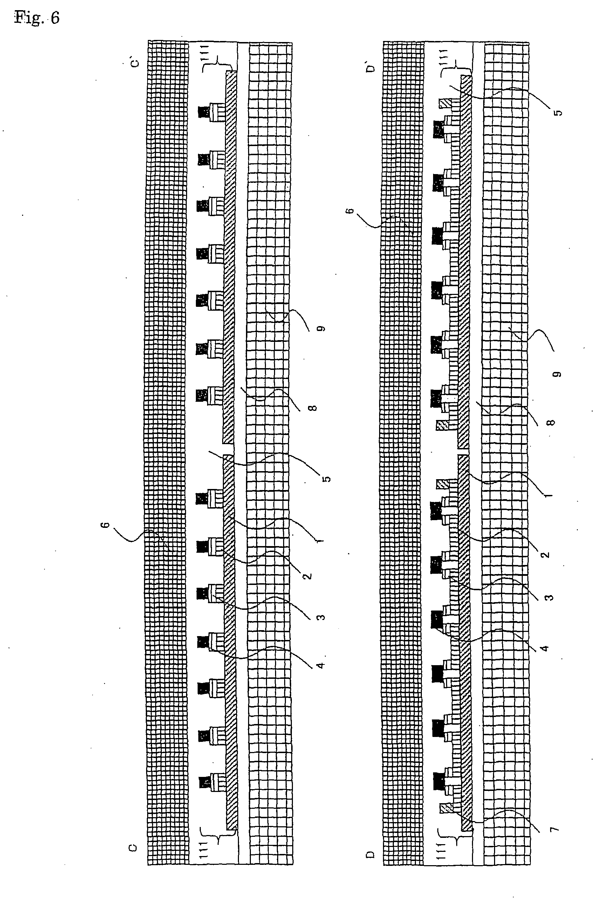

Next, screen printing was used to print an electroconductive silver paste for adhesion as an electroconductive adhesive layer 3 onto land patterns 22/22 at both ends of each gap 23. Thereafter, each chip LED 4 as a light emitting element was used, and the chip LED 4 was mounted with a mounter in such a manner that both polarities of the chip LED 4 were made electrically conductive through the electroconductive silver paste for adhesion printed on the land patterns 22/22 at both the ends of each of the gaps 23 for the gap 23 not to cause electric non-conductance of the circuit pattern 10. Thereafter, the silver paste was thermally cured at a temperature of 150 °C for 10 minutes to attain the adhesion of the chip LED 4. In this way, structures 111 as illustrated in Figs. 5 and 6 were each formed.

As a third substrate 9 having electric non-conductance, a glass substrate (substrate size: 560 mm x 650 mm) 4.0 mm in thickness was used, and an EVA layer was used as an adhesive layer 8. The four structures 111 were formed thereon so as to arrange the structures in a planar form. These structures 111 were connected to each other through wirings 7. An EVA layer as an adhesive layer 5 was formed thereon. Specifically, an EVA layer 8 having a larger thickness than the height of the chip LEDs 4 was sandwiched, and further a glass 4.0 mm in thickness as a second insulating substrate 6 was put thereon. The resultant was kept at a temperature of 130 °C for 20 minutes to melt the EVA, and then kept at a temperature of 150 °C for 45 minutes to crosslink the EVA.

The light emitting module produced in this way can be caused to emit light into a scattered dot pattern having a large area in a simple way, and further exhibits excellent reliability. In the case of considering a combination of the first, second and third substrates 1, 6 and 9, a light emitting module having a large area and corresponding to various use purposes can be provided.

### INDUSTRIAL APPLICABILITY

The light emitting module of the invention can be combined with a solar battery or some other cell, so as to be widely applied to a large-sized illuminance or a light emitting device such as a guide sign.

## Claims

1. A light emitting module, comprising a structure wherein over a first substrate having at least electric non-conductance, an electroconductive layer, an electroconductive adhesive layer, light emitting elements the number of which is predetermined, a transparent adhesive layer, and a second substrate having translucency are successively laminated in this order, wherein the electroconductive layer has a circuit pattern for causing the light emitting elements to emit light.

2. The light emitting module according to claim 1, wherein the first substrate and the second substrate are each a film, a glass substrate, or a plastic substrate.

3. The light emitting module according to claim 1, wherein the electroconductive layer is made of an electroconductive paste, a metal foil, or a metal film.

4. The light emitting module according to claim 1, wherein the first substrate is a film, and the film has therein a metal foil layer or a metal film layer.

5. The light emitting module according to claim 1, wherein the circuit pattern is a pattern wherein a plurality of lines of light emitting elements connected in series are connected in parallel with each other.

6. The light emitting module according to claim 1, wherein the transparent adhesive layer is made of low-temperature crosslinking type EVA.

7. A light emitting module, comprising a first substrate having electric non-conductance, and one structure wherein at least an electroconductive layer, an electroconductive adhesive layer and light emitting elements the number of which is predetermined are successively laminated in this order, the structure being over the first substrate and being sandwiched between second substrate having translucency and third substrate, and an adhesive layer being interposed between each of the second and third substrates and the structure.

8. A light emitting module, comprising a first substrate having electric non-conductance, and a plurality of structures in each of which at least an electroconductive layer, an electroconductive adhesive layer and light emitting elements the number of which is predetermined are successively laminated in this order, the structures being over the first substrate, being connected to each other in a planar form, and being sandwiched between second substrate having translucency and third substrate, and an adhesive layer being interposed between each of the second and third substrates and the structures.

9. The light emitting module according to one of claims 7 and 8, wherein the third substrate is a film, a glass substrate or a plastic substrate.

10. The light emitting module according to one of claims 7 and 8, wherein between the third substrate and the adhesive layer, a reflecting layer covering the whole or a part of the surface of the third substrate is formed.

11. A method for producing a light emitting module according to one of claims 1, 7 and 8, comprising the steps of printing or painting an electroconductive paste on a first substrate into a predetermined pattern, and then setting the paste thermally, thereby yielding a circuit pattern of an electroconductive layer.

12. A method for producing a light emitting module according to one of claims 1, 7 and 8, comprising the steps of laminating a metal foil on a first substrate through an adhesive, painting a resist material on this metal foil, radiating light thereon into a predetermined pattern, developing the resist material, etching unnecessary portions to remove the portions, and then removing the resist material, thereby yielding a circuit pattern of an electroconductive layer.

13. A method for producing a light emitting module according to one of claims 1, 7 and 8, comprising the steps of forming a metallic film on a first substrate by vapor deposition or sputtering, painting a resist material on this metal film, radiating light thereon into a predetermined pattern, developing the resist material, etching unnecessary portions to remove the portions, and then removing the resist material, thereby yielding a circuit pattern of an electroconductive layer.

14. A method for producing a light emitting module according to one of claims 1, 7 and 8, comprising the steps of: using an electroconductive paste for adhesion to form a predetermined pattern of an electroconductive adhesive layer on a first substrate when light emitting elements are caused to adhere to an electroconductive layer through the electroconductive adhesive layer; mounting the light emitting elements on the pattern; and subsequently setting the paste thermally.

15. A method for producing a light emitting module according to one of claims 1, 7 and 8, comprising the steps of: using creamy solder to form a predetermined pattern of an electroconductive adhesive layer on a first substrate when light emitting elements are caused to adhere to an electroconductive layer through the electroconductive adhesive layer; mounting the light emitting elements on the pattern; and subsequently subjecting the resultant to heating treatment by means of a reflow furnace.

16. A light emitting device, comprising a light emitting module according to one of claims 1, 7 and 8, and a solar cell.
